# EUROPEAN PATENT APPLICATION

(11) **EP 2 599 749 A1**
(43) Date of publication of application: **05.06.2013**
(21) Application number: 11382370.2
(22) Date of filing: 30.11.2011
(51) Int. Cl.: C01F 7/02, C01F 7/46, C30B 33/02

(54) **Method for the purification of alpha-alumina fibers**

(71) Applicant: Neoker, S.L, 15895 Milladoiro - Ames (A Coruna) (ES)
(72) Inventor: Cerecedo Fernández, Carmen, E-15895 Ames - A Coruña (ES); Valcárcel Juárez, Víctor, E-15895 Ames - A Coruña (ES); Guitián Rivera, Francisco, E-15895 Ames - A Coruña (ES); Caamaño Castro, Jose Miguel, E-15895 Ames - A Coruña (ES); Rodriguez Carreira, Alfredo, E-15895 Ames - A Coruña (ES)
(74) Representative: ABG Patentes, S.L.

(57) **Abstract**

The present invention relates to a method for the purification of α-Al₂O₃ whiskers previously obtained by vapor-liquid-solid deposition, under metal vapors-containing atmospheres. Said method involves the volatilization of metal impurities in controlled-atmosphere furnaces at the surface of the fibers and from the drops at the end of the fibers. The invention also relates to purified α-Al₂O₃ whiskers obtainable by a process as defined above and substantially free from metal impurities at the surface and at the end part of the fibers, as well as the use of the purified α-Al₂O₃ whiskers as defined above as fillers or reinforcement agents for the preparation of ceramic, metallic or polymeric composites.

## Description

### Field of the Invention

The present invention relates to a method for the purification of α-Al₂O₃ whiskers previously obtained by vapor-liquid-solid deposition (VLS), under metal vapors-containing atmospheres. Said method involves the volatilization of metal and oxide impurities in controlled-atmosphere furnaces.

### Background

Fiber-reinforced composites can sustain higher loadings than the unreinforced equivalent matrixes, having superior mechanical properties. Composites reinforced with continuous fibers offer outstanding specific strength and stiffness along the fiber direction when compared to those with particulate reinforcements that have more isotropic properties.

However, the use of fiber-reinforced composites is limited at elevated temperatures due to oxidation; therefore, stable oxide fibers, principally alpha-alumina (α-Al₂O₃, corundum), are the best candidates. Their lightweight, high stiffness, high fatigue strength and abrasion resistance, as well as their excellent performance at high temperatures make alumina-reinforced composites ideal in different structural applications. For example, in forming sheets for thermal insulation; and as filler/reinforcing agents for ceramic, metallic or plastic composites (CMC's, MMC's and PMC's respectively) with different areas of applications such as construction, aerospace, power utility, automotive, and military sectors.

A critical parameter of fibers is their length-to-diameter ratio or aspect ratio. This ratio must be >20-150 for noticeable enhancements, and higher aspect ratios should proportionally increase the reinforcement. For this reason, polycrystalline fibers present many drawbacks, because grain growth occurs as the temperature is increased, with a subsequent decrease in tensile strength. Consequently, the mechanical properties of polycrystalline Al₂O₃ fibers decrease quickly at >1000°C. Grain growth at high temperatures is usually restricted by additives, resulting in decreased grain growth and improved resistance.

A different approach to overcoming this inconvenience is the use of whiskers (monocrystalline alumina fibers), which are superior to polycrystalline fibers, because they possess enhanced mechanical properties and do not exhibit grain growth.

Very few methods of producing mono-crystalline α-Al₂O₃ fibers at industrial scale are available since they need for very expensive crystallization surfaces (such as sapphire as described in the document US 4,806,198) or high temperatures (sometimes above the α-Al₂O₃ melting point, 2050°C), among other factors. α-Al₂O₃ whiskers have also been prepared by vapor-phase methods, under which aluminum powder is heated in the presence of hydrogen and an inorganic silicon compound at 1100°-1450°C as described in US 3,514,256 (GB849051).

ES2146506 describes a methods using vapor-liquid-solid deposition (VLS) to produce Al₂O₃ whiskers under inert atmospheres that uses a characteristic fiber ending drop mechanism, using more affordable starting materials. However, improvements were required to this method, due mainly to instability of the existing species at the liquid phase at the given temperature (1550°C). ES2182684 described the addition of selected transition metals (mainly Ni and Co, and their corresponding metal oxides) to aluminum and powdered silica in Ar atmospheres at 1550-2050°C. The resulting atmospheres (containing small amounts of metal vapors) cause a significant increase in the production and quality of α-Al₂O₃ fibers. ES 2204291 further introduces different routes to generate the transition metal vapors for the same method, such as acid/basic dissolution of the metal species, or metal ion implantation techniques.

The use of transition metals was previously described in the vapor-phase formation of α-alumina fibers as part of the ceramic material to form the receptacle and including silica and iron oxide, and to lesser degree, titania, chromium oxide, zirconium oxide or cobalt oxide (GB1203342, US 3,788,935, US 3,668,062 and US 3,421,85). These oxides appear to function beneficially in the process but further mechanistic explanation is not mentioned. EP0640382 describes the formation of alumina whiskers over metal fiber having composition of Fe-Ni-Cr-Al, Fe-Cr-Al or Ni-Cr-Al at 800-1000°C.

As a result of the use of transitional metals (or the corresponding metallic oxides), they accumulate in small amounts in the drops that allow growth by deposition of alumina single crystals. These drops are placed at the end of the fibers and must be eliminated in order to inhibit oxide whisker formation. According to J. Am. Ceram. Soc. 2003, 86, 1683-1690, these drops can be removed by an acid attack.

In fact, it is well-known in the state of the art the use of strong acids for the purification of alumina whiskers(EP0375325). US 4,536,379 describes the use of fluorhydric acid to purify SiC whiskers. ES 2278528 (and J. Europ. Ceram. Soc. 2006, 26, 1561-1565) describes the purification of alfa-alumina fibers produced by partial pressures of oxidant agents with a mixture of HF and nitric acid. Oxygen flows at 800°C have been described in US 3,947,562 (GB1489346) as purification method of alumina-fibers.

However, any of these purification steps were used for eliminating transition metal impurities. Early in 1965, US 3,391,681 claimed the purification of alumina whiskers formed by VLS using transition metals such as Ni or Co, by mechanically separating the metals from the fibers, or by further treating the fibers with a selective mixture of strong acids, such as nitric or sulphuric acid. WO90/14451 claimed also a two steps method for the purification of metal carbides, nitrides and carbonitrides whiskers produced by chemical vapor deposition (CVD) using a Ni catalyst. In the first step, the whiskers are treated with HCl at 350-400°C and Ar pressure to convert the residual Ni catalyst to NiCl₂. In the second step, whiskers are heated at 1000°C and Ar pressure to sublime NiCl₂.

In all these cases, the authors found that the purification step did not affect the structure of the alumina whiskers. However, these methods do not eliminate completely the metal impurities, being able to eliminate only the metals placed in the drops at the end of the fiber, but not at the surface of the fibers. W02009/102815 claimed a hydrothermal method for the production of α-alumina fibers at pressures higher than 100KPa. In this method, the use of strong acids and strong bases are mentioned to eliminate impurities at the surface of the fibers coming from the use of binders such as CaSiO₃ MgSiO₃, ZrO₂, TiO₂ or SiO₂. However, it has been observed contamination in the internal structure of the fibers after the purification step.

Therefore, there is a clear need to develop a new method for treating alumina-fibers or whiskers formed by VLS, in order to remove the metal impurities deposited during the growth mechanism. Such method must remove both impurities in the drops at the end of the fibers and at the surface of the fibers in such a way that contamination in the internal structure of the fibers is avoided.

### Brief description of the Invention

The authors of the present invention have developed a new method which allows removing metal impurities accumulated in alpha-alumina whiskers during their preparation by vapor-liquid-solid deposition (VLS) in the presence of metal vapors atmospheres.

The method of the invention is based on the volatilization of the impurities in the solid phase, a process occurring when liquid impurities in non-aqueous phase or dissolved in water come into contact with a gaseous phase. On this way, the impurities are transferred from the fiber surface to the gaseous phase. This is an advantage over existing purification methods since the metal impurities can be eliminated both from the surface and from the drops at the end of the fibers without affecting the internal structure of the whiskers.

Another advantage of the method of the invention is its selectivity to metal impurities without affecting other fibers' components. Under the conditions used to carry out the method of the invention, in particular the use of vacuum at oxygen partial pressure lower than 10⁻¹atm and temperatures ranging from 1400 and 2000°C, the aluminum oxide is more stable than the metals and oxides forming the impurities to be removed, such as NiO, Ni₂O₃ and Fe₂O₃.

Thus, the method of the invention allows the removal of impurities of metals, in particular Si and/or metals such as Ni, Co and Fe, either in metallic or oxide forms, both from the surface and from the drops at the end of the fibers. However, the structure of the aluminum oxide constituting the fibers remains unalterable.

It should also be pointed out that the purification method of the invention is performed in only one step without requiring the employ of agents commonly used to purify the aluminum fibers, such as strong acids or bases, which contaminate the alumina fibers affecting their composition and/or structure. By the present method, the treated alumina whiskers are produced with purity higher than 99.97%.

Therefore, a first aspect of the present invention relates to α-Al₂O₃ whiskers obtainable by vapor-liquid-solid deposition under atmospheres containing transition metal vapors, characterized in that said α-Al₂O₃ whiskers are substantially free from metal impurities at the surface and in the drops located at the end part of the whiskers.

In a second aspect, the present invention refers to a method for the purification of α-Al₂O₃ whiskers obtainable by vapor-liquid-solid deposition under atmospheres containing transition metal vapors, said method comprises the volatilization of metal impurities from the surface of the fibers and from the drops at the end of the fibers.

Another aspect of the present invention relates to purified α-Al₂O₃ whiskers obtainable by a process as defined above.

Finally, another aspect of the invention refers to the use of purified α-Al₂O₃ whiskers as defined above as fillers or reinforcement agents for the preparation of ceramic, metallic or polymeric composites.

### Description of the Drawings

Figure 1 show the XRD patterns of the purified α-whiskers.
Figure 2 shows a SEM micrograph of VLS α-alumina whiskers before the purification treatment.
Figure 3 shows a SEM micrograph of the purified VLS α-alumina whiskers.
Figure 4 shows EDX analysis for the alpha-alumina whiskers before the purification treatment corresponding to the SEM analyses.
Figure 5 shows EDX analysis for the purified alpha-alumina whiskers corresponding to the SEM analyses.

### Detailed Description of the Invention

The present invention relates to a new method for the purification of α-Al₂O₃ whiskers obtainable by vapor-liquid-solid deposition under atmospheres containing transition metal vapors, said method comprises the volatilization of metal impurities from the surface of the fibers and from the drops at the end of the fibers.

In a particular embodiment, the α-Al₂O₃ whiskers to be purified by the method of the invention are previously obtainable by a vapor-liquid-solid deposition method (VLS) with a fiber ending drop mechanism under inert atmospheres and the addition of selected transition metals that improves the amount of produced α-Al₂O₃ fibers.

A method for the preparation of α-Al₂O₃ fibers by a vapor-liquid-solid deposition method (VLS) is described in patent application ES2182684 and in the example 1 of the present application.

In the context of the present invention, the term "vapor-liquid-solid deposition method (VLS)" stands for Vapor (V) feed gases, Liquid catalyst (L), and Solid crystalline (S) whisker growth. The presence of a liquid catalyst is what distinguishes this method from all other whisker growth techniques. The role of the catalyst is to form a liquid solution interface with the crystalline material to be grown and fed from the vapor through the liquid-vapor interface. The catalyst solution is a preferred site for deposition of feed from the vapor which causes the liquid to become super-saturated. Fiber growth occurs by precipitation from the super-saturated liquid at the solid-liquid interface. In view of this mechanism, catalyst selection is partially based upon the fact that the catalyst must display the affinity, when molten, to take into solution the constituent atoms of the whisker one wishes to grow. For alumina whisker growth, transition metals satisfy this requirement.

In the context of the present invention, the term "fiber ending drop mechanism" stands for the droplet needed for the VLS process. The VLS mechanism is typically described in three stages: 1. preparation of a liquid alloy droplet upon the substrate from which a wire is to be grown; 2. introduction of the substance to be grown as a vapor, which adsorbs on to the liquid surface, and diffuses in to the droplet; and 3. Super-saturation and nucleation at the liquid/solid interface leading to axial crystal growth.

In a particular embodiment, step 1 takes place automatically, the droplet formation occurs via chemical reaction of the reactives.

α-Al₂O₃ whiskers are readily produced by this method and grow into a white, cotton-like mass of crystals around the aluminum piece. Each fiber had a hexagonal section, drops at one of its ends, and one basal hexagonal pyramid. The fibers had aspect ratios higher than 10³ up to 10⁴. The drops at the ends of the fibers demonstrate that the fibers had grown via VLS deposition. ICP analysis revealed that the purity of the VLS α-Al₂O₃ whiskers is up to 98.5%. The impurities are adhered to the surface of the fibers and inside the VLS drops.

In the present invention, a purification process has been developed to remove the metal impurities without affecting the composition "inside" the fibers.

Therefore, a first aspect of the present invention refers to α-Al₂O₃ whiskers obtainable by vapor-liquid-solid deposition under atmospheres containing transition metal vapors, characterized in that said α-Al₂O₃ whiskers are substantially free from metal impurities at the surface of the whiskers and in the drops located at the end part of the whiskers.

In the context of the present invention, the term "metal impurities" refers to any metal element or metal oxide present both at the surface of the α-Al₂O₃ whiskers and in the drops at the end of the α-Al₂O₃ whiskers, but not in the internal structure of the α-Al₂O₃ whiskers.

By the term "substantially free from metal impurities" must be understood as α-Al₂O₃ whiskers having less than 350 ppm of metal impurities or oxides thereof. Preferably, α-Al₂O₃ whiskers have less than 200 ppm, more preferably, less than 150 ppm of transition metal impurities.

In a particular embodiment, α-Al₂O₃ whiskers of the invention have less than 200 ppm of Si, more preferably less than 150 ppm of Si, or an oxide thereof.

In another particular embodiment, α-Al₂O₃ whiskers of the invention have less than 150 ppm ofNi, more preferably less than 120 ppm of Ni, or an oxide thereof.

In another particular embodiment, whiskers of the invention have less than 50 ppm of Fe, more preferably less than 25 ppm of Fe, or an oxide thereof.

In another particular embodiment, whiskers of the invention have less than 10 ppm of Co or an oxide thereof.

Even, in another particular embodiment of the invention α-Al₂O₃ whiskers of the invention have a purity higher than 99.97%.

In a second aspect, the present invention relates to a method for the purification of α-Al₂O₃ whiskers obtainable by vapor-liquid-solid deposition under atmospheres containing transition metal vapors, said method comprises the volatilization of metal impurities from the surface of the whiskers and from the drops present at the end of the whiskers.

The proposed method is based on obtaining purified alpha-alumina fibers through the selective volatilization of the metal impurities using low oxygen pressure atmospheres. The volatilization occurs when liquid metal impurities in non-aqueous phase or dissolved in water come into contact with a gaseous phase. The metal impurities then reach their vapor pressure which is the gas pressure in equilibrium with respect to the solid or liquid at a given temperature. On this way, the metal impurities are transferred from the fiber surface to the gaseous phase.

To this end, a controlled-atmosphere device is used.

In a particular embodiment of the invention, the volatilization comprises subjecting the α-Al₂O₃ whiskers at vacuum with an oxygen partial pressure lower than 10⁻¹ atm O₂ and at a temperature ranging from 1400 to 2000°C.

In a preferred embodiment, the oxygen partial pressure is lower than 7*10⁻² atm O₂, even more preferably lower than 10⁻² atm O₂.

In another preferred embodiment, the temperature ranges from 1500 to 1700°C. More preferably, the temperature is reached by a temperature-increase rate of 5°C/min.

In another preferred embodiment, the temperature is maintained during at least one hour, more preferably during at least two hours.

After that, the system can be cooled to room temperature, preferably to 25°C, maintaining the vacuum during the whole process.

More preferably, the volatilization process is carried out in a controlled-atmosphere furnace chamber.

This method allows removing any metal impurities in the alpha-alumina whiskers. In a particular embodiment, the impurities to be removed are Si and/or one or more transition-metals selected from Ni, Co, Fe, and others transition metals that could remain molten between 1550-2050°C under the oxygen partial pressures mentioned above. The transition metals can be in the form of both metallic elements and their oxides, for example Ni, Ni₂O, Fe, Fe₂O₃, etc.

The metal impurities are removed both from the surface of the fibers and from the drops at the end of the fibers, but never from "inside" the fibers' structure.

More preferably, the metal impurities to be removed are Si and/or one or more transition-metals selected from Ni, Co and Fe. Even more preferably, the impurities to be removed are one or more transition-metals selected from Ni, Co and Fe.

### Examples

### Example 1. Preparation of α-Al₂O₃ whiskers

α-Al₂O₃ whiskers were prepared by placing aluminum wires (diameter 4 mm, length 1 cm) of 99.9 wt% purity onto a powder bed. The powders in the bed were composed of quartz sand with the addition of various percentages of metals (or metal oxides) of transition metals such as Ni, Fe or Co. The metals used were in the form of either powders or small pieces (balls, etc.), whereas the metal oxides used were always fine powders (<63 µm). The programmed temperature cycles used consisted of an initial temperature-increase rate of 10°C/min to a plateau temperature that is maintained for 2-4 h, after which the system was cooled to room temperature, at a rate of 10°C/min. The plateau temperature was maintained at 1300°-1600°C, although a temperature of 1550°C was used most of the times. Furnaces with inert atmospheres of argon gas were used, and a 0.2 L/min argon flux was maintained during the temperature-increase and the temperature-decrease step. The furnace tube remained closed and airtight during the periods of constant temperature.

### Example 2: Purification of α-Al₂O₃ whiskers

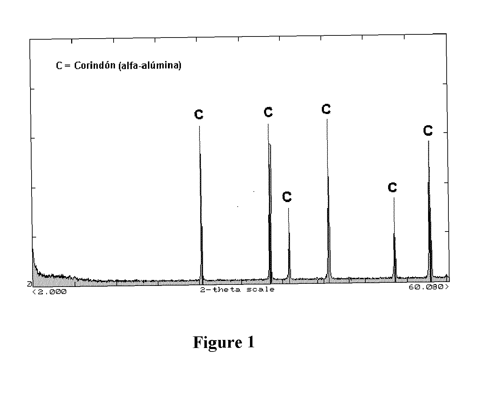

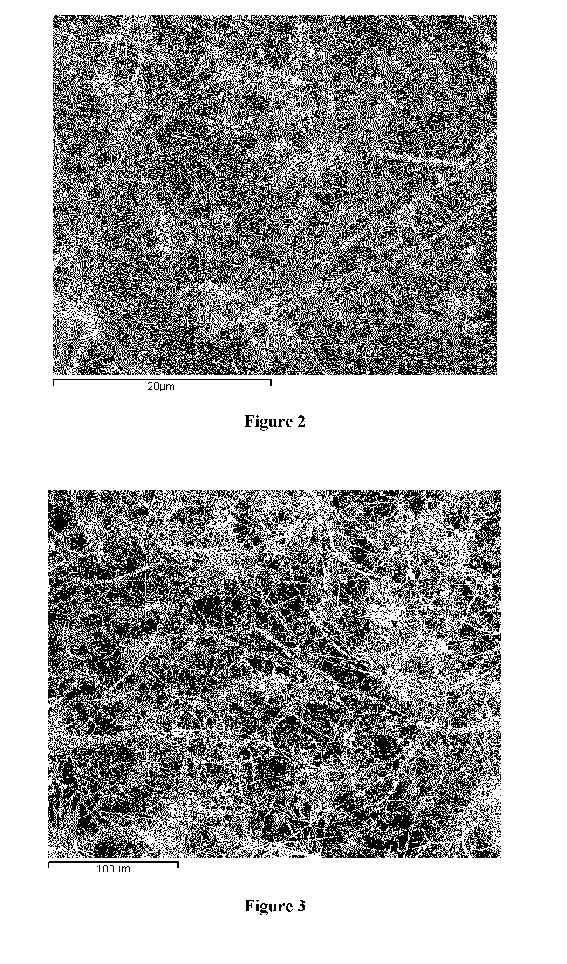

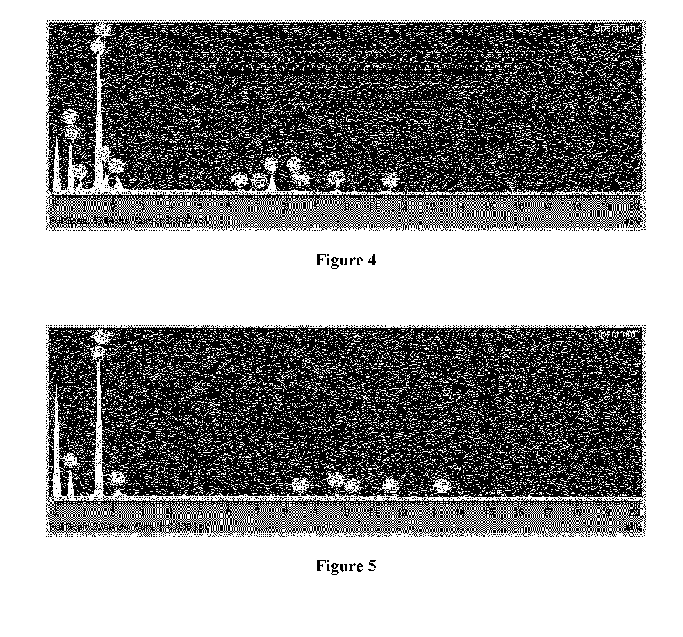

Fibers, with an average size of 0.5 microns in diameter and 100 microns to 1 mm of lengths, were placed over 4 alumina ceramic trays of dimensions 15×15×1 cm. They were then introduced inside the furnace chamber stacked one above the other with the help of alumina brackets. The furnace was then closed and airtight by vacuum reaching an oxygen partial pressure of 6×10⁻² atm. Then, the programmed temperature cycle started with an initial temperature-increase rate of 5°C/min to a plateau temperature at 1650°C maintained for 2 h, after which the system was cooled to room temperature. The purified alumina whiskers were characterized by X-ray diffraction, and the analysis revealed that the only existing crystalline phase is the phase for the corundum or alpha-alumina (Fig. 1). Analysis by Chemical analysis ICP revealed alumina fibers with purity higher than 99.97%, due to the complete elimination of the transition metal impurities from the fibers (Table 1). Detailed analyses of the whiskers before and after the purification treatment *via* scanning electron microscopy (SEM) are depicted in Figure 2 and 3, respectively. Fig. 4 shows drops containing impurities at the end of the fibers and at the surface of the fibers. As shown in Figure 3, after the purification treatment, these drops are gone. The complete elimination can be confirmed by Energy-Dispersive X-ray spectroscopy analyses (EDS) which showed the actual purity of the fibers before and after the purification treatment (Fig. 4 and Fig. 5, respectively).

**Table 1**

| | | | **Metal Content (ppm)** | | | | | | |
|---|---|---|---|---|---|---|---|---|---|
| **Whisker sample** | *Si* | *Ni* | | *Fe* | *Ca* | *Na* | *Mg* | *Co* | *Purity (%)* |
| *Before purification* | 10150 | 12135 | | 8823 | 141 | 738 | 48 | 10 | 96.70 |
| *After purification* | 150 | 120 | | 23 | 9 | 7 | 3 | 2 | 99.97 |

## Claims

1. α-Al₂O₃ whiskers obtainable by vapor-liquid-solid deposition under atmospheres containing transition metal vapors, **characterized in that** said α-Al₂O₃ whiskers are substantially free from metal impurities at the surface of the whiskers and in the drops located at the end part of the whiskers.

2. α-Al₂O₃ whiskers according to claim 1, having less than 350 ppm of metal impurities or oxides thereof.

3. α-Al₂O₃ whiskers according to any of claims 1 or 2, having less than 200 ppm of transition metal impurities or oxides thereof.

4. α-Al₂O₃ whiskers according to any of claims 1 to 3, having a purity higher than 99.97%.

5. A method for the purification of α-Al₂O₃ whiskers obtainable by vapor-liquid-solid deposition under atmospheres containing transition metal vapors, said method comprises the volatilization of metal impurities from the surface of the whiskers and from the drops present at the end of the whiskers.

6. The method according to claim 5, wherein the volatilization comprises subjecting said α-Al₂O₃ whiskers at vacuum with an oxygen partial pressure lower than 10⁻¹ atm O₂ and at a temperature ranging from 1400 to 2000°C.

7. The method according to claim 6, wherein the oxygen partial pressure is lower than 7*10⁻² atm O₂.

8. The method according to claims 7 or 8, wherein the temperature ranges from 1500 to 1700°C.

9. The method according to any of claims 6 to 8, wherein the temperature is maintained during at least one hour.

10. The method according to any of claims 5 to 9, which is carried out in a furnace chamber.

11. The method according to any of claims 5 to 10, wherein the metal impurities to be removed are Si and/or one or more transition-metals selected from Ni, Co and Fe and oxides thereof.

12. Purified α-Al₂O₃ whiskers obtainable by a process as defined in any of claims 5 to 11.

13. Use of α-Al₂O₃ whiskers as defined in any of claims 1 to 4 or 12, as fillers or reinforcement agents for the preparation of ceramic, metallic or polymeric composites.

14. A ceramic, metallic or polymeric composite comprising α-Al₂O₃ whiskers as defined in any of claims 1 to 4 or 12.
